# EUROPEAN PATENT APPLICATION

(11) **EP 1 536 373 A1**
(43) Date of publication of application: **01.06.2005**
(21) Application number: 03794211.7
(22) Date of filing: 03.09.2003
(51) Int. Cl.: G06K 19/077, G06K 19/07, H01L 21/60

(54) **RFID TAG**

(30) Priority: 04.09.2002 JP 2002258391
(71) Applicant: Hitachi, Ltd., Tokyo 100-8280 (JP)
(72) Inventor: OOZEKI, Yoshio, c/o Production Eng. Res. Lab., Yokohama-shi, Kanagawa 244-0817 (JP); NAKANO, Asao, c/o Production Eng. Res. Lab., Yokohama-shi, Kanagawa 244-0817 (JP)
(74) Representative: Strehl Schübel-Hopf & Partner
(86) International application number: PCT/JP2003/011267
(87) International publication number: WO 2004/023392

(57) **Abstract**

It is possible to provide an RFID tag having less poor connections. The present invention can solve the above problem by using a structure of an RFID tag which includes a metallic antenna and a semiconductor device in which a terminal is connected to the antenna, wherein the semiconductor device is smaller than 0.5-mm square and is connected to the antenna through metal connection.

## Description

### TECHNICAL FIELD

### FIELD OF THE INVENTION

The present invention relates to an RFID tag.

### DESCRIPTION OF THE PRIOR ART

A general semiconductor-device mounting technique can be roughly classified under wire bonding and wireless bonding.

Because the wire bonding performs bonding so as to draw an arc between a terminal of a semiconductor device and a pad of a wiring board, it is not suited to achieve an RFID tag decreased in thickness.

On the other hand, the wireless bonding is suited to decrease the thickness of the RFID tag because the distance between the terminal of the semiconductor device and the wiring board is short and the terminal and the wiring board can be straight connected, thereby.

The wireless bonding includes contact connection and metal connection.

As an example of the contact connection, JP-A-2001-24568 discloses a mounting method using an anisometric conductive film (ACF) (hereafter referred to as an ACF connection method).

According to this document, since it becomes possible to omit the wire bonding or molding by resin due to connecting an IC with an antenna by means of the ACF connection method, it is said that the method is preferred to decrease the thickness of a card.

### BRIEF SUMMARY OF THE INVENTION

Employees belonging to the applicants have developed a semiconductor device for an RFID tag of 0.5 mm square or less. Therefore, the present inventors have studied to apply the ACF mounting method used for the above wireless IC card in order to mount the semiconductor device on an antenna.

As a result of actually fabricating the semiconductor devices, some of there devices have poor contacts with antennas.

That is, it has been found that the mounting technique of a semiconductor device in the order of several-mm square used for the above wireless IC card cannot be directly applied to mounting of a semiconductor device of 1-mm square or less, particularly of 0.5-mm square or less (0.25 mm² or less in terms of area) and thus, it is necessary to study other parameters.

Therefore, it is an object of the present invention to improve the connection reliability of an RFID tag on which a semiconductor device of 0.5-mm square or less is mounted.

This problem can be solved by the following configuration. If a semiconductor device smaller than 0.5 mm square is constructed to connect to a metallic antenna through the metal connection, it is unnecessary to care about curing contractive force or thermal contractive force as is the case with the contact connection. Therefore, even if using a semiconductor device having a large terminal area per unit area, connection failure does not easily occur.

Moreover, it is preferable that metal connection is made by an alloy of gold and tin, in order to realize lead free and short tact.

To realize these structures, it is preferable to use a semiconductor device of less than 0.5-mm square in which a gold bump is formed on a terminal, and an antenna in which copper foil is tin-plated, because it is possible to restrain the consumption of expensive gold.

Other objects, features, and advantages of the present invention will become apparent from the description of the following embodiments of the present invention about accompanying drawings.

An RFID tag of the present invention is described below by referring to the accompanying drawings.

### BRIEF DESCRIPTION OF THE SEVERAL VIEWS OF THE DRAWINGS

Fig. 1 shows a top view and a sectional view of an RFID tag;
Fig. 2 is an enlarged transmitted view of a connective portion between a semiconductor device and an antenna;
Fig. 3 is an illustration showing characteristics about the connection resistance value of an RFID tag;
Fig. 4 is a mounting structure using an ACF method;
Fig. 5 is an illustration showing characteristics about the connection resistance value of an RFID tag when connected in accordance with the ACF method;
Fig. 6 is an illustration showing the rates of contact failure of the ACF method and the metal connection method of gold and tin; and
Fig. 7 is an illustration showing strengths when an under-fill is present and absent.

### DETAILED DESCRIPTION OF THE INVENTION

### (Embodiment 1)

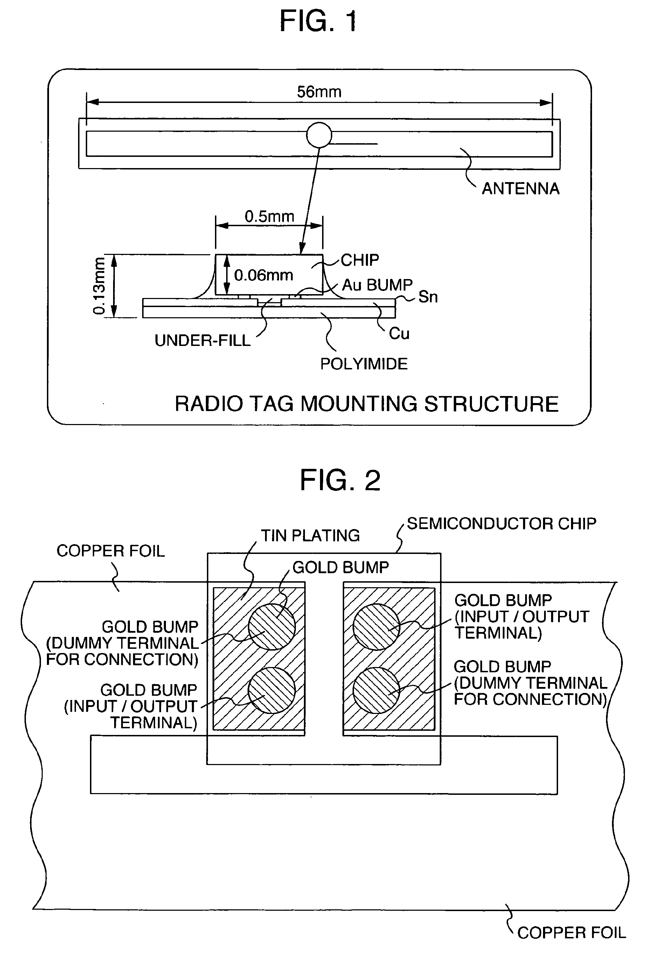

Fig. 1 shows a top view and a sectional view of an RFID tag, and Fig. 2 shows an enlarged transmitted view of the connective portion between a semiconductor device and an antenna.

As shown in Fig. 1, the RFID tag of this mode is a semiconductor device mounted on an antenna in accordance with a flip chip method having an ID oscillation function, and has a thickness of 0.13 mm as a whole.

Moreover, the semiconductor device is background so as to have a thickness of 0.06 mm and has a contour of 0.5-mm square. Furthermore, four terminals, which comprise two input/output terminals directly connected with an integrated circuit in the semiconductor device by wirings and two connection terminals not directly connected with the integrated circuit in the semiconductor device, are formed as an input/output terminal, a connection terminal, an input/output terminal, and a connection terminal, in this order, by separating from each other every 90° about the center of mass of the semiconductor device (namely, input/output terminals are faced each other and connection terminals are faced each other). Furthermore, the semiconductor device is a semiconductor device receiving a microwave in a 2.45-GHz band by an antenna and operating by using self rectification occurred from a microwave as a power source, and has a function for converting 128-bit data stored in a built-in memory into a transmission signal by using reception of the microwave signal as a trigger to return the signal to the antenna.

Furthermore, the antenna is a copper foil having a length of 56 mm and being formed at an outer edge on a polyimide tape with a slight gap and a tin plated film is formed at an end of the antenna on which the semiconductor device is mounted.

All of the terminals of the semiconductor device and the copper foil of the antenna are connected by an alloy of gold and tin.

Furthermore, an under-fill is set between a side and a downside of the semiconductor device, and the copper foil.

Because the connection terminal is provided to secure the balance of connection, it is also allowed to use only two input/output terminals and one connection terminal.

This structure can be fabricated by the following steps.

Step 1: An antenna is formed by bonding a copper foil on one principal plane of a polyimide film (polyimide tape) which is a resin film, by using an adhesive. Tin is plated on the bonded copper foil to use it as a connection pad (connection electrode).

Step 2: Then, a gold bump is formed on all terminals of a semiconductor device.

Step 3: The antenna is fixed so that the tin plated at step 1 becomes the uppermost layer. Moreover, the antenna is aligned with the semiconductor device by turning a terminal surface of the semiconductor device down so that the gold bump formed in step 2 is faced with the tin.

Step 4: by applying a pressure of 200 MPa from an upper portion of the semiconductor device which is a non-terminal surface to a lower portion of the device and simultaneously, by heating it at 150°C for 1.5 sec, the semiconductor device is temporarily fixed.

Step 5: More accurate alignment is performed, and the semiconductor device is pressed at a pressure of 200 MPa and heated at 280°C for 3 sec. Because tin is diffused in gold according to the heating, the terminal of the semiconductor device and the copper foil of the antenna become metal connection by a gold-tin alloy.

Step 6: An under-fill is formed under the semiconductor device.

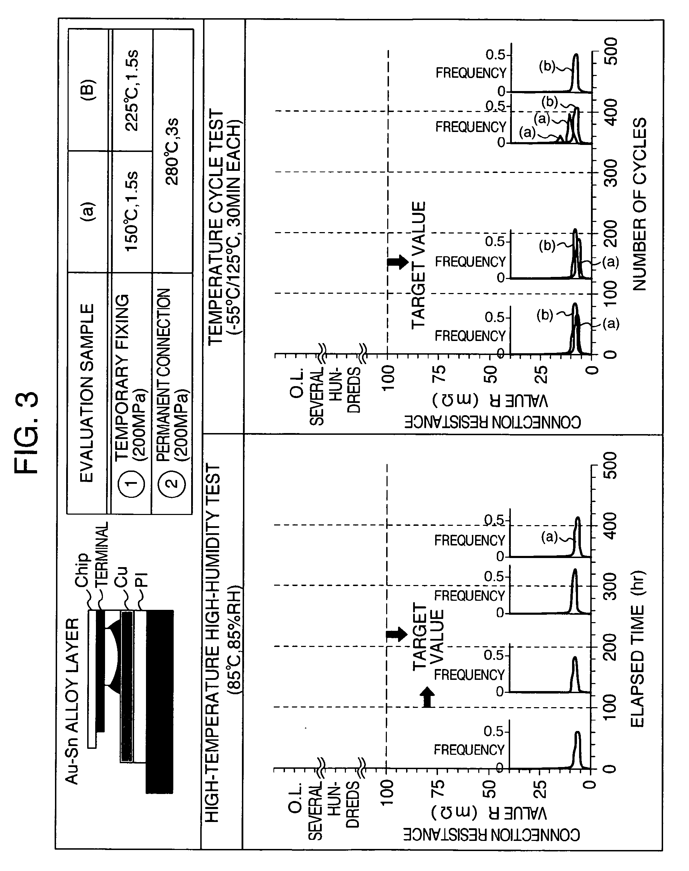

Then, characteristics about the connection resistance value of the RFID tag of this mode are described below by referring to Fig. 3.

The RFID tag manufactured by the above manufacturing method shows the characteristics of (a) in Fig. 3.

As a result of a high-temperature and high-humidity test at 85°C and 85% RH, only a connection resistance of approx. 10 mΩ is generated at an approx. 350 cycles. Because it has been known that the transmission characteristic is influenced at an approx. 100 mΩ, it can be said that this characteristic is a preferable connection resistance.

As a result of a temperature cycle test of - 50°C to 125°C for 30 min each, only a connection resistance of 20 mΩ or less is generated at 350 cycles. Therefore, it can be said that it is a preferable resistance similarly to the case of the high-temperature and high-humidity test.

When setting the temporary fixing temperature in the above manufacturing step 4 to 225°C and when performing a temperature cycle test, only approx. 10 mΩ is generated at 430 cycles. Therefore, a preferable connection resistance can be obtained similarly to the case in which the temporary fixing temperature is set to 150°C.

As described in the above, in the case of the RFID tag of this mode, since the metal connection is used for connection between a semiconductor device of 0.5-mm square or less and an antenna, it is possible to preferably reduce poor connections.

Moreover, this structure uses an alloy of tin and gold as a metal to be connected. By constituting the structure like this, it is possible to not only realize a lead-free RFID tag but also improve the connection reliability by a short tact even for a small pitch.

Furthermore, it is possible to obtain an effect even if applying such a connection method to one of an input/output terminal and a connection terminal. However, by using the method for both terminals, the batch reflow method becomes applicable.

Furthermore, since the input/output terminals have the same function, by using the method for both terminals, it is possible to connect the terminals in reverse directions by 180° by arranging those to face the opposite angles of the semiconductor devices.

Furthermore, by using a structure in which two tin-plated terminals of the antenna, that is, one input/output terminal and one connection terminal are connected by one connection terminal, it is possible to obtain a structure in which poor connection does not occur even if a slight rotation shift occurs. Furthermore, in the case of this structure, it is possible to perform connection even if rotating it by 90° or 270°. Therefore, it is possible to make connection easier.

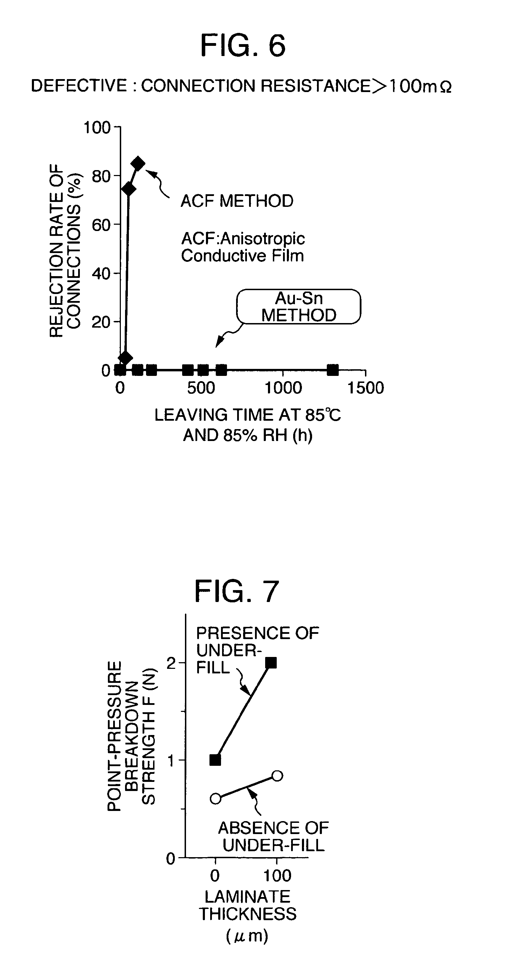

Fig. 7 shows a difference between strengths when an under-fill is present and absent.

As described in the above, the semiconductor device of this embodiment is decreased in thickness by back-grinding it. By this back-grinding, small microcracks are caused in the semiconductor device. When forming an under-fill on this structure, it is found that the semiconductor device becomes strong two times or more against the external point-pressure breakdown, compared to the case in which there is no under-fill.

### (Comparative Example)

Then, a case of performing mounting in accordance with the ACF method which is a contact connection method is described as a comparative example.

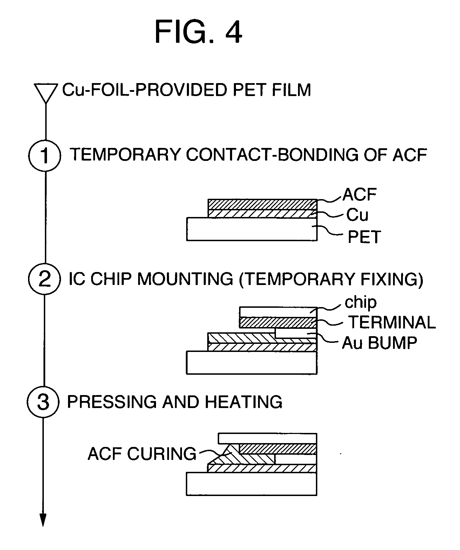

Fig. 4 shows a mounting method when using the ACF method.

An antenna is formed by bonding a copper foil having a length of 56 mm on a transparent polyethylene terephthalate film (hereafter referred to as a PET film).

An ACF is temporarily pressure-connected onto the bonded copper foil.

A gold bump is formed on the semiconductor device, and the semiconductor device and the antenna are arranged so that the gold bump and the ACF face each other, and the semiconductor device and the antenna are temporarily fixed.

More accurate alignment is performed again to press and heat those. The ACF is cured through the pressing and heating and the gold bump and copper foil are directly connected.

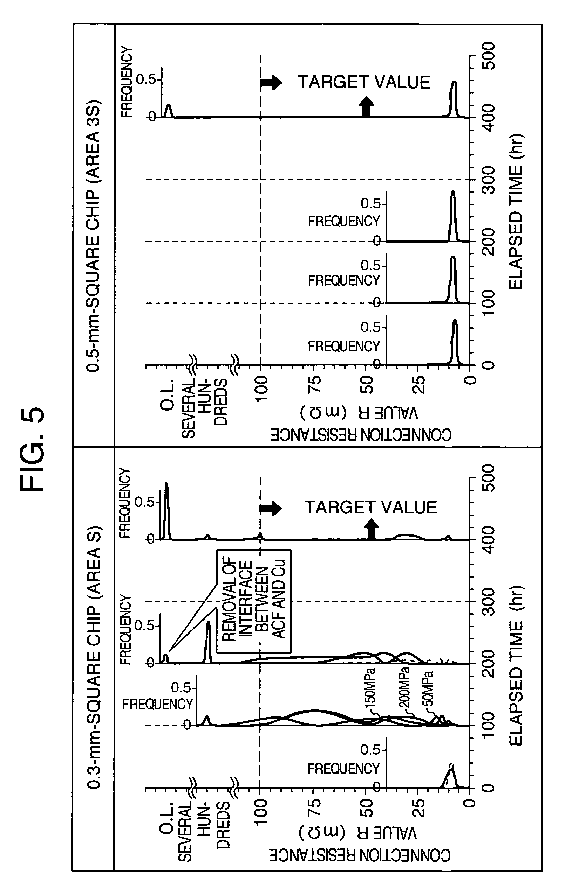

Fig. 5 shows results of a high-temperature high-humidity test (85°C and 85% RH) when connecting the gold bump and copper foil manufactured through the method in Fig. 4 in accordance with the ACF method.

When mounting a semiconductor device of 0.3-mm square, a connection resistance of hundreds of mΩ is generated for 25 hours.

Also, when mounting a semiconductor device of 0.5-mm square, a connection resistance of hundreds of mΩ or more is generated when 100 hours have passed. Thus, when using the ACF method to mount a semiconductor device of 0.5-mm square or less, a remarkable increase of a connection resistance occurs, which does not occur in a conventional semiconductor device.

Because a normal semiconductor device has many regions having no terminal, it is possible to sufficiently secure the area of an ACF per terminal even if many terminals are used and obtain a desired connection stability. However, in the case of the semiconductor device of 0.5-mm square or less of this embodiment constituting an RFID tag, the terminal area becomes very large to the device area. Therefore, the bonding power of the ACF per terminal (thermal contractive force + curing contractive force) is decreased and thus it is considered that the connection stability with the copper foil is degraded.

In Fig. 6, connection failure rates of the ACF method, and the metal connection method of gold and tin are compared.

In the case of RFID tags using the ACF method, an poor connection starts to occur before 1 hr passes, and approx. 85% of the tags becomes defective before 50 hr pass.

On the other hand, in the case of the gold-tin connection method, preferable connection having a rate of defective of 1% or less can be kept after 1,300 hr pass.

According to the present invention, it is possible to provide an RFID tag having less poor connections.

The above description is made for the embodiment. However, the present invention is not restricted to the embodiment. It is clear for those skilled in the art that various modifications and corrections can be made in accordance with the spirit of and within claims of the present invention.

## Claims

1. An RFID tag comprising a metallic antenna, and a semiconductor device in which a terminal connected to the antenna, **characterized in that**
the semiconductor device is smaller than 0.5-mm square, and connected to the antenna by means of metal connection.

2. The RFID tag according to claim 1,
**characterized in that**
the metal connection is made by an alloy of gold and tin.

3. An RFID tag comprising an antenna in which a copper foil is attached onto a polymer film, and a semiconductor device in which a terminal is connected to the copper foil, **characterized in that**
the RFID tag use the semiconductor device smaller than 0.5-mm square in which a gold bump is formed on the terminal, and the antenna in which tin is plated on the copper foil.

4. The RFID tag according to any one of claims 1-3, **characterized in that**
the terminal includes an input/output terminal.

5. The RFID tag according to claim 4, **characterized in that**
the terminal includes a connection terminal.

6. An RFID tag comprising an antenna, and a semiconductor device provided with two input/output terminals connected to the antenna, **characterized in that**
the semiconductor device is a semiconductor device in which the input/output terminals are arranged at opposing corner positions of the semiconductor device.

7. The RFID tag according to claim 6, **characterized in that**
the semiconductor device is further provided with two connection terminals arranged at the other opposing corner positions of the semiconductor device.

8. The RFID tag according to claim 7, **characterized in that**
the antenna is provided with two connection terminals, and
one connection terminal of the antenna is connected with two adjacent terminals of the semiconductor device.
